# EUROPEAN PATENT APPLICATION

(11) **EP 4 266 183 A1**
(43) Date of publication of application: **25.10.2023**
(21) Application number: 21914171.0
(22) Date of filing: 24.12.2021
(51) Int. Cl.: G06F 13/16

(54) **DATA STORAGE AND COMPUTER DEVICE**

(30) Priority: 30.12.2020 CN 202011617059; 05.02.2021 CN 202110161484
(71) Applicant: Huawei Technologies Co., Ltd., Shenzhen, Guangdong 518129 (CN)
(72) Inventor: ZHU, Xiaoming, Shenzhen, Guangdong 518129 (CN); JING, Weiliang, Shenzhen, Guangdong 518129 (CN)
(74) Representative: Huawei European IPR
(86) International application number: PCT/CN2021/141015
(87) International publication number: WO 2022/143434

(57) **Abstract**

Embodiments of this application disclose a storage device and a computer device, and belong to the field of computer technologies. The storage device includes a first PCM 1, a main memory 2, and a controller 3. The first PCM 1 and the controller 3 are packaged in a same chip. A latency of the first PCM 1 is less than that of the main memory 2, and storage density of the main memory 2 is greater than that of the first PCM 1. The controller 3 is configured to store data in the first PCM 1 and the main memory 2 based on a read/write temperature of the data, where the first PCM 1 is a cache of the main memory 2. According to embodiments of this application, a cache capacity of the storage device can be increased, and device costs can be reduced.

## Description

### TECHNICAL FIELD

This application relates to the field of computer technologies, and in particular, to a storage device and a computer device.

### BACKGROUND

With the development of computer technologies, a processing capability of a central processing unit (central processing unit, CPU) is growing rapidly and continuously. However, a dynamic random access memory (dynamic random access memory, DRAM) as a memory is limited by physical characteristics and techniques, and cannot meet a requirement of the CPU. Many supplementary storage solutions for the DRAM emerge accordingly.

These supplementary storage solutions generally use a large-capacity main memory that is used together with a static random access memory (static random access memory, SRAM) or a DRAM that serves as a cache.

In a process of implementing this application, the inventor finds that the related technology has at least the following problems.

Although the SRAM and the DRAM each have a low latency, storage density of the SRAM is very low, an area occupied by the SRAM in a storage device is excessively large, and the SRAM has a very limited capacity. In addition, both the SRAM and the DRAM are volatile memories. Consequently, a power failure protection mechanism needs to be set, and this greatly increases costs.

### SUMMARY

Embodiments of this application provide a storage device and a computer device, to resolve problems of a low cache capacity and high costs of the storage device. The technical solutions are as follows.

According to a first aspect, a storage device is provided. The storage device includes a first PCM 1, a main memory 2, and a controller 3. The first PCM 1 and the controller 3 are packaged in a same chip. A latency of the first PCM 1 is less than that of the main memory 2, and storage density of the main memory 2 is greater than that of the first PCM 1. The first PCM 1 is a cache of the main memory 2. The controller 3 is configured to store data in the first PCM 1 and the main memory 2 based on a read/write temperature of the data.

The storage device may be a memory or a solid-state drive. Packaging of the first PCM 1 and the controller 3 may be 2D packaging or 3D packaging.

The first PCM 1 and the main memory 2 are separately connected to the controller 3 through a line. The first PCM 1 and the controller 3 are connected through an on-chip line. In 3D packaging, the first PCM 1 and the controller 3 are connected through a vertical line between dies. The main memory 2 and the controller 3 may be connected to each other through a line on a PCB. The PCB that provides the line connection may be a PCB inside the storage device, or may be a PCB of another device or part outside the storage device, or may include both the PCB inside the storage device and the PCB outside the storage device. Alternatively, line connection between the main memory 2 and the controller 3 may not be performed via a PCB. Alternatively, the main memory 2, the first PCM 1, and the controller 3 may be packaged in a same chip. A 2D packaging manner or a 3D packaging manner may be used for the main memory 2, the first PCM 1, and the controller 3.

The controller 3 may perform storage scheduling on to-be-stored data and/or stored data in the first PCM 1 and the main memory 2 based on a read/write temperature of the data. A read/write temperature of data of the first PCM 1 is higher than a read/write temperature of data of the main memory 2.

If a PCM with a low latency is used as a cache, the PCM media with the low latency can provide high storage density and a GB-level storage capacity while the latency is as low as 20 ns, so that a latency, an occupied area, and a cached data amount are effectively balanced. In addition, data can be retained for several days after a power failure. In this way, for some enterprise-level application scenarios (in which a device is powered on again in short time after a power failure), a power failure protection mechanism does not need to be set, and manufacturing costs of the storage device can be well reduced.

In the foregoing control logic of the controller 3, the controller 3 stores data with a high read/write temperature in the first PCM 1, and stores data with a lower read/write temperature in the main memory 2. In this way, because a CPU frequently reads and writes data that is the data with a higher read/write temperature and seldom performs a read/write operation on the data with a lower read/write temperature, and the read/write temperature of the data of the first PCM 1 is higher than the read/write temperature of the data of the main memory 2, a latency indicated by the storage device to the outside is mainly the latency of the first PCM 1, and a latency of the main memory 2 is basically not perceived by the outside of the storage device. In this way, an advantage of high storage density and a large capacity of the main memory 2 can be well utilized, and it can be ensured that a problem of a high latency of the main memory 2 does not cause an excessively large impact on the latency indicated by the entire storage device to the outside.

In a possible implementation, packaging of the first PCM 1 and the controller 3 is 3D packaging, and the first PCM 1 and the controller 3 are in different dies of the chip.

The 3D packaging chip may include two or more dies. The controller 3 may be disposed in one or more dies, and the first PCM 1 may also be disposed in one or more dies. The controller 3 may be disposed above and the first PCM 1 may be disposed below, or the first PCM 1 may be disposed above and the controller may be disposed below, or the like.

In a 3D packaging manner, the PCM and the controller are located in different dies, and the PCM and the controller are stacked, so that the PCM and the controller do not repeatedly occupy an area, and an occupied area can be reduced. In addition, the PCM and the controller are connected through a line in a vertical direction. Compared with a line in a horizontal direction, the line in the vertical direction occupies a much smaller area, and may be basically considered not to occupy an area, thereby further reducing the occupied area.

In a possible implementation, the controller 3 is configured to perform a read/write operation on the first PCM 1.

The controller 3 may include an operation circuit of the first PCM 1. The operation circuit may be an independent unit in the controller 3, or the operation circuit may not be set as an independent unit, and processing logic of the operation circuit of the first PCM 1 is integrated into processing logic of the controller 3.

In embodiments of this application, in a manner of packaging into a chip, the PCM and the controller are connected at a chip level, and are connected to a large quantity of lines. The controller may directly perform a read/write operation on data that is in a storage medium of the PCM. In this way, a conventional operation circuit may not be disposed inside the PCM. Further, in a data read/write process, protocol communication between the controller and the operation circuit is also omitted, and data read/write on the PCM is not limited by a conventional protocol between the controller and the operation circuit, so that data read/write is more flexible and efficient.

In a possible implementation, the main memory 2 is a second PCM or a NAND memory.

The second PCM may be a PCM having high storage density, or may be referred to as a high-density PCM. Both the high-density PCM and the NAND memory have high storage density, and therefore can provide a large storage capacity in limited space occupation.

In a possible implementation, the first PCM 1 is a GB-level memory, and the main memory 2 is a TB-level memory; or the first PCM 1 is an MB-level memory, and the main memory 2 is a GB-level memory. Storage levels of the first PCM 1 and the main memory 2 may be flexibly set based on a requirement, and only some possible examples are provided herein.

In a possible implementation, the first PCM 1 and the controller 3 are packaged in a CPU 4.

An entirety including the first PCM 1 and the controller 2 may be a physically relatively independent unit in the CPU 4. Alternatively, the first PCM 1 may be used as a cache of the CPU 4, for example, an L4 cache, and the controller 2 may be a storage control unit of the CPU 4.

There is an on-chip connection line between the controller 3 and another unit of the CPU 4, and communication may be performed through the on-chip connection line. The connection is a chip-level connection, can greatly reduce a latency of communication between the controller 3 and another unit of the CPU 4, and can improve transmission efficiency of the storage device.

In a possible implementation, the storage device further includes a PCB 5 having a DDR interface 51, and the main memory 2 is disposed on the PCB 5.

A product form of the main memory 2 may be designed into a standard DIMM module form, so that the main memory 2 may be compatible with a DIMM slot of a general mainboard, and the main memory 2 may be used as an independent memory module.

In a possible implementation, the storage device further includes a PCB 6, and the chip and the main memory 2 are disposed on the PCB 6.

In this structure, the storage device is a complete integrated hardware module, and the chip in which the first PCM 1 and the controller 3 are packaged and the main memory 2 are connected to a same PCB. The controller 3 and the main memory 2 are connected through a line on the PCB 6 to perform communication, and the controller 3 and the first PCM 1 are connected through an on-chip line to perform communication. In this structure, the product has better integrity.

In a possible implementation, the PCB 6 has a DDR interface 61.

In this way, a product form of the entire memory is a DIMM module, and the DDR interface 61 may be well compatible with a standard DIMM slot.

In a possible implementation, the PCB 6 has a PCIe interface 62.

In this way, a product form of the entire memory is a PCIe card, and the PCIe interface 62 may be well compatible with a standard PCIe slot.

In a possible implementation, a communication protocol between the controller 3 and a CPU 4 is a PCIe protocol or a CXL protocol.

The storage device and the CPU 4 may communicate with each other based on the PCIe protocol. The storage device supports I/O semantic access, in other words, supports block addressing. The storage device may also communicate with the CPU 4 based on the CXL protocol. The storage device supports both memory semantic access and I/O semantic access, in other words, supports both byte addressing and block addressing.

In a possible implementation, a communication protocol between the controller 3 and a CPU 4 is a proprietary protocol.

The storage device communicates with the CPU 4 based on the proprietary protocol, and has higher data read/write flexibility.

In a possible implementation, the controller 3 supports a parallel bus communication standard, a serial bus communication standard, or a customized bus communication standard.

In a possible implementation, a communication protocol between the controller 3 and the main memory 2 is an ONFI protocol, a toggle protocol, or a proprietary protocol.

According to a second aspect, a computer device is provided. The computer device includes the storage device according to the first aspect and the possible implementations of the first aspect.

Beneficial effects brought by the technical solutions provided in embodiments of this application are as follows.

In embodiments of this application, the PCM with the low latency is used as a cache. The PCM medium with the low latency can still have high storage density while the latency is as low as 20 ns, and can reach a GB-level large storage capacity. In addition, data can be retained for a few days after a power failure, and the power failure protection mechanism does not need to be set, thereby reducing costs. The controller stores the data with a higher read/write temperature in the PCM, and stores the data with a lower read/write temperature in the main memory. In this way, an advantage of high storage density and a large capacity of the main memory can be well utilized, and it can be ensured that a problem of a high latency of the main memory does not cause an excessively large impact on a latency indicated by the entire storage device to the outside. In a 3D packaging manner, the PCM and the controller are located in different dies, so that the PCM and the controller do not repeatedly occupy an area, and an occupied area can be reduced. In addition, the PCM and the controller are connected through a line in a vertical direction, and the line in the vertical direction does not occupy an area, thereby further reducing the occupied area. In addition, the PCM and the controller are packaged in a same chip. The PCM and the controller are connected at a chip level, and may be connected to a large quantity of lines. The controller may directly perform a read/write operation on data in the PCM. In this way, a conventional operation circuit does not need to be disposed inside the PCM. Correspondingly, data read/write on the PCM is not limited by a conventional protocol between the controller and the operation circuit, so that data read/write is more flexible and efficient.

### BRIEF DESCRIPTION OF DRAWINGS

FIG. 1 is a schematic diagram of a structure of a storage device according to an embodiment of this application;
FIG. 2 is a schematic diagram of a structure of a storage device according to an embodiment of this application;
FIG. 3 is a schematic diagram of a structure of a storage device according to an embodiment of this application;
FIG. 4 is a schematic diagram of a structure of a storage device according to an embodiment of this application;
FIG. 5 is a schematic diagram of a structure of a storage device according to an embodiment of this application;
FIG. 6 is a schematic diagram of an internal structure of a computer device according to an embodiment of this application;
FIG. 7 is a schematic diagram of an internal structure of a computer device according to an embodiment of this application; and
FIG. 8 is a schematic diagram of an internal structure of a computer device according to an embodiment of this application.

### Reference numerals

1. First PCM; 2. Main memory;
3. Controller; 4. CPU;
5. PCB; 51. DDR interface;
6. PCB; 61. DDR interface;
62. PCIe interface

### DESCRIPTION OF EMBODIMENTS

An embodiment of this application provides a storage device. The storage device is used in a computer device, and the computer device may be a server, a terminal, or the like. The storage device may be an external device of the computer device, or may be a built-in part of the computer device. The storage device may be a complete integrated device, or may be a device including a plurality of separate parts. The storage device may be an independent part that can be detachably connected to the computer device, or may be a part that is integrally manufactured with another part of the computer device. From a perspective of a product function, the storage device may be used as a supplementary memory of a conventional DRAM memory, or may be used as an independently used memory, or may be used as a hard disk, or may be used as a cache of a hard disk, or the like.

The following first explains some technical terms in this application.

A phase change memory (phase change memory, PCM) stores data by using an electrical conductivity difference that is of a special material and that is shown when the special material is converted between a crystalline state and an amorphous state. The phase change memory is usually an information storage apparatus that stores data by using a large conductivity difference between a crystalline state and an amorphous state of chalcogenide. There are many materials for a storage medium of the PCM, and attribute parameters of the materials are different.

A DRAM is a semiconductor memory, and a main working principle is that a binary bit (bit) is represented by using a value relationship between a quantity of electric charges stored in a capacitor and a threshold, where a value of the bit is 1 or 0. In reality, because a transistor may have a leakage current phenomenon, the quantity of electric charges stored in the capacitor is not enough to correctly perform data determining, and consequently data is damaged. Therefore, for the DRAM, periodic charging (also referred to as refreshing) is an inevitable condition. Because of this feature of a requirement for periodic refreshing, the DRAM is called a "dynamic" random access memory. Relatively speaking, provided that data is stored in a static random access memory, the data is not lost even if the data is not refreshed.

The SRAM is a type of random access memory. "Static" means that provided that the SRAM is kept powered on, the data stored in the SRAM can be constantly stored. Relatively speaking, data stored in the DRAM needs to be periodically refreshed. However, when power supply stops, the data stored in the SRAM still disappears, in other words, both the SRAM and the DRAM are volatile memories (volatile memories). This is different from a read-only memory (read-only memory, ROM) or a flash memory that can still store data after a power failure.

A dual in-line memory module (dual in-line memory module, DIMM) is a series of modules including DRAMs. The DIMM is usually in a form of several to dozens of DRAM chips that are welded and mounted on a printed circuit board that has a manufactured circuit, and is used in a computer device such as a personal computer, a workstation, or a server. A DIMM slot is generally disposed on the computer device, and is configured to connect to a DIMM memory module.

Three-dimensional (three-dimensional, 3D) packaging is a chip packaging technology in which more than two dies (dies) are stacked in a same chip in a vertical direction, and the dies are connected to each other through a large quantity of lines in the vertical direction for data transmission. Each die may be considered as a layer of the chip. By contrast, in two-dimensional (two-dimensional, 2D) packaging, a plurality of vertically stacked dies do not exist. For a chip formed through 2D packaging, a plurality of parts are connected through lines in a horizontal direction. Compared with lines in a vertical direction, the lines in the horizontal direction waste a larger chip area.

A peripheral component interconnect express (peripheral component interconnect express, PCIe) is a high-speed serial computer expansion bus standard used for data transmission between a CPU and other parts of a computer device, replaces a conventional peripheral component interconnect (peripheral component interconnect, PCI) standard, and has a higher transmission bandwidth and transmission rate.

The double data rate (double data rate, DDR) joint electron device engineering council (joint electron device engineering council, JEDEC) standard is a parallel bus communication standard, and includes physical specifications of connection interfaces and data transmission-related protocols.

A read/write temperature is quantized information that indicates read/write frequency of data. Higher read/write frequency of the data indicates a higher read/write temperature, and lower read/write frequency of the data indicates a lower read/write temperature. A specific quantization manner may be set to any form based on an actual requirement. For example, in a common quantization manner, the read/write temperature includes three values: hot, warm, and cold. The hot, warm, and cold are classified based on read/write frequency thresholds. If the read/write frequency of the data is greater than a first frequency threshold, it is determined that the data is hot data. If the read/write frequency of the data is less than a second frequency threshold, it is determined that the data is cold data. If the read/write temperature of the data is between the first frequency threshold and the second frequency threshold, it is determined that the data is warm data.

A latency is an attribute of a storage medium in a memory, and is duration needed for performing data read/write on the storage medium once. Generally, a low latency of a storage medium may reach several nanoseconds (ns), and a high latency of a storage medium may be hundreds of ns or several milliseconds (ms). For example, a latency of a DRAM is generally about 80 ns.

Storage density is an attribute of a storage medium in a memory, and may be considered as a quantity of memory cells in a storage medium of a unit volume. The memory cell is a storage medium configured to store 1-bit data. The storage density may also be considered as an amount of data that can be stored in the storage medium of the unit volume.

A printed circuit board (printed circuit board, PCB), also called a printed writing board, is an important electronic part, is a support body of an electronic component, and is a carrier for electrical connection of the electronic component. The PCB is referred to as the "printed" circuit board because the PCB is manufactured through an electronic printing technology. A large quantity of conductors are printed on the PCB and used as connection lines between different electronic components.

A solid-state drive (solid-state drive, SSD) is a hard disk made of a solid-state electronic storage chip array.

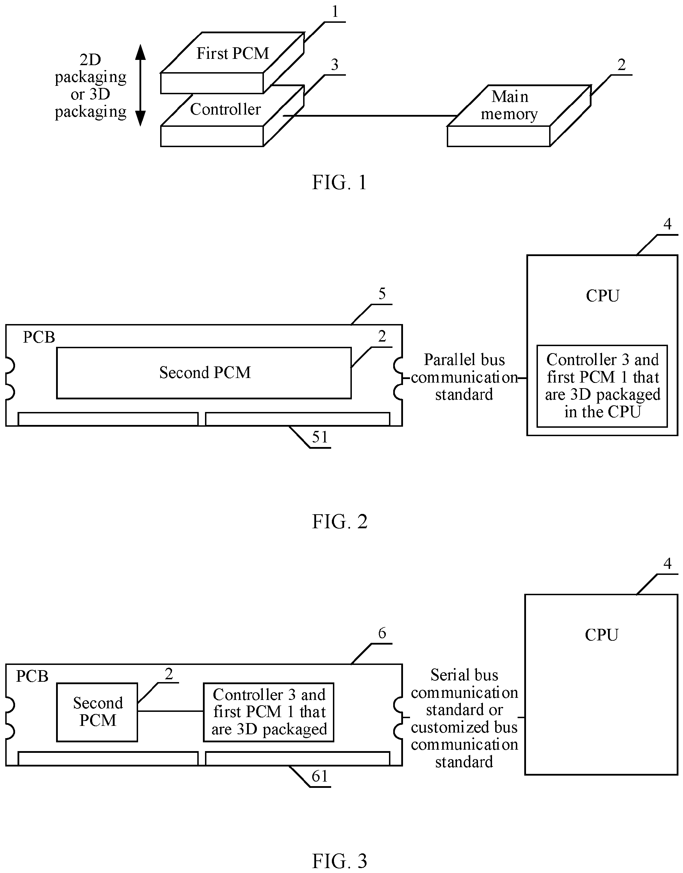

An embodiment of this application provides a storage device. Refer to FIG. 1. A structure of the storage device may be as follows.

The storage device includes a first PCM 1, a main memory 2, and a controller 3. The first PCM 1 and the controller 3 are packaged in a same chip. A latency of the first PCM 1 is less than that of the main memory 2, and storage density of the main memory 2 is greater than that of the first PCM 1.

### The following describes parts in the storage device.

For a storage medium of the first PCM 1, there are many optional materials, and a material with a lower latency may be selected, for example, a latency that is about 20 ns or that is less than 20 ns. Correspondingly, the first PCM 1 may also be referred to as a low-latency PCM. A mixture of scandium (Sc), antimony (Sb), and tellurium (Te) may be selected as a material of the low-latency PCM. A latency of a material selected for a storage medium of a PCM is within 20 ns, and storage density is generally low. Nevertheless, when a latency of 20 ns and a proper area size are met, the first PCM 1 can still reach a gigabyte (gigabyte, GB)-level storage capacity. In actual use, the first PCM 1 may be a GB-level memory or may be a megabyte (mbyte, MB)-level memory.

If a PCM with a lower latency is used as a cache, the PCM media with the low latency can provide high storage density and a GB-level storage capacity while the latency is as low as 20 ns, so that a latency, an occupied area, and a cached data amount are effectively balanced. In addition, data can be retained for several days after a power failure. In this way, for some enterprise-level application scenarios (in which a device is powered on again in short time after a power failure), a power failure protection mechanism does not need to be set, and manufacturing costs of the storage device can be well reduced.

The main memory 2 may be a second PCM or a not and (not and, NAND) memory, or may be another memory that uses a storage medium having high storage density. The second PCM may be referred to as a high-density PCM, and a mixture of germanium (Ge), antimony, and tellurium may be selected as a material of the high-density PCM. The main memory 2 may reach a terabyte (terabyte, TB)-level storage capacity. In actual use, the main memory 2 may be a TB-level memory or a GB-level memory.

The first PCM 1 may be considered as a cache, a latency of the first PCM 1 and a latency of the main memory 2 may meet a specific proportional relationship, and the latency of the first PCM 1 and a storage capacity of the main memory 2 may meet a specific proportional relationship. For example, a ratio of the latency of the first PCM 1 to the latency of the main memory 2 may be within a range of 15 to 30, and a ratio of the latency of the first PCM 1 to the storage capacity of the main memory 2 may be within a range of 1/500 to 1/1000.

The controller 3 may be an independent controller configured to control data read/write on the storage device, and control logic is used to control data read/write only on the first PCM 1 and the main memory 2. Alternatively, the controller 3 may be a comprehensive controller having more control functions, and controlling data read/write on the storage device is only a part of functions of the controller 3. Control logic of various functions in the controller 3 is deployed together, and is not physically divided for different units. The controller 3 may include an operation circuit of the first PCM 1. The operation circuit may be an independent unit in the controller 3, or the operation circuit may not be set as an independent unit, and processing logic of the operation circuit of the first PCM 1 is integrated into processing logic of the controller 3.

### The following describes a specific structure of the storage device.

Packaging of the first PCM 1 and the controller 3 may be 2D packaging or 3D packaging. In embodiments of this application, 3D packaging is used as an example for detailed description of the solution. During 3D packaging, the first PCM 1 and the controller 3 are in different dies of the chip. The 3D packaging chip may include two or more dies. The controller 3 may be disposed in one or more dies, and the first PCM 1 may also be disposed in one or more dies. The controller 3 may be disposed above and the first PCM 1 may be disposed below, or the first PCM 1 may be disposed above and the controller may be disposed below, or the like. For example, the chip includes two dies, one die is the controller 3, and the other die is the first PCM 1; or the chip includes three dies, an upper die is the controller 3, and a middle die and a lower die are first PCMs 1.

The first PCM 1 and the main memory 2 are separately connected to the controller 3 through a line. The first PCM 1 and the controller 3 are connected in a same chip through a vertical line between dies. The main memory 2 and the controller 3 may be connected to each other through a line on a PCB. The PCB that provides the line connection may be a PCB inside the storage device, or may be a PCB of another device or part outside the storage device, or may include both the PCB inside the storage device and the PCB outside the storage device. Alternatively, line connection between the main memory 2 and the controller 3 may not be performed via a PCB. Alternatively, the main memory 2, the first PCM 1, and the controller 3 may be packaged in a same chip. A 2D packaging manner or a 3D packaging manner may be used for the main memory 2, the first PCM 1, and the controller 3.

The main memory 2 and the packaging chip may be disposed on a same PCB. In this way, the storage device is an entire component. For example, the storage device may be an SSD drive, or the storage device may be a memory of a PCIe interface. The chip and the main memory 2 are disposed separately. In this way, the storage device is made into two separate subparts.

The storage device may be connected to the outside in various forms, and may use a parallel bus interface, a serial bus interface, or a customized bus interface, or may not use a pluggable interface, and the storage device is directly manufactured in another device during manufacture of the another device.

In a 3D packaging manner, the PCM and the controller are located in different dies, and the PCM and the controller are stacked, so that the PCM and the controller do not repeatedly occupy an area, and an occupied area can be reduced. In addition, the PCM and the controller are connected through a line in a vertical direction. Compared with a line in a horizontal direction, the line in the vertical direction occupies a much smaller area, and may be basically considered not to occupy an area, thereby further reducing the occupied area.

In addition, an operation circuit is disposed in a conventional PCM. Because the PCM and the controller are not connected at a chip level, and a quantity of connection lines is small, the controller cannot directly read/write data in a storage medium of the PCM, and the operation circuit is needed to help perform data read/write in the PCM. In other words, the PCM is packaged with the operation circuit and the storage medium, the operation circuit and the storage medium are connected to each other at a chip level, and the operation circuit can directly perform a data read/write operation on the storage medium. A corresponding protocol is set between the controller and the operation circuit, and the controller and the operation circuit communicate with each other through the protocol, to send instructions and feed back results. A protocol generally specifies a unit data amount of data read/write. In this way, if an amount of data to be read is less than the unit data amount, data of the unit data amount also needs to be read, and then desired data is obtained from the data of the unit data amount. For an application scenario with high frequency and a small data amount, processing efficiency is severely affected.

In embodiments of this application, in a 3D packaging manner, the PCM and the controller are connected at a chip level, and are connected to a large quantity of lines. The controller may directly perform a read/write operation on the data that is in the storage medium of the PCM. In this way, a conventional operation circuit may not be disposed inside the PCM. Further, in a data read/write process, protocol communication between the controller and the operation circuit is also omitted, and data read/write on the PCM is not limited by a conventional protocol between the controller and the operation circuit, so that data read/write is more flexible and efficient.

### The following describes functions of the parts in the storage device.

The controller 3 is configured to store data in the first PCM 1 and the main memory 2 based on a read/write temperature of the data.

A person skilled in the art may set corresponding read/write temperatures for the first PCM 1 and the main memory 2 in advance. Herein, the corresponding read/write temperatures may be set based on latencies of different memories, and a memory with a lower latency is set to store data with a higher read/write temperature. The latency of the first PCM 1 is less than that of the main memory 2. Therefore, the first PCM 1 is set to store data with a higher read/write temperature, and the main memory 2 is set to store data with a lower read/write temperature. For example, the read/write temperature includes hot, warm, and cold. The first PCM 1 may be set to store hot data, and the main memory 2 may be set to store warm data and cold data; or the first PCM 1 may be set to store hot data and warm data, and the main memory 2 may be set to store cold data. A specific setting may be determined by comprehensively considering a ratio of hot data, warm data, and cold data and a ratio of a storage capacity of the first PCM 1 to the storage capacity of the main memory 2 in an application scenario.

Based on the foregoing setting, storage scheduling may be performed on to-be-stored data and/or stored data in the first PCM 1 and the main memory 2 based on the read/write temperature of the data. There may be many methods for performing storage scheduling. The following briefly describes several feasible methods.

### Method 1

When receiving the to-be-stored data sent by a CPU 4, the controller 3 determines the data as hot data, and stores the hot data into the first PCM 1. For all stored data, the controller 3 determines, each time periodicity duration elapses, that a read/write temperature of the data is hot, warm, or cold based on the read/write frequency of the data within the current periodicity duration, and then re-determines a memory of the data based on the read/write temperature of the data. If the newly determined memory is different from a memory in which the data is currently located, the data is migrated to the newly determined memory. For example, if data in the first PCM 1 changes to cold data, the data is migrated to the main memory 2. If cold data in the main memory 2 changes to hot data, the data is migrated to the first PCM 1.

### Method 2

When sending the to-be-stored data to the controller 3, a CPU 4 sends a read/write temperature corresponding to the data. After receiving the data and the corresponding read/write temperature, the controller 3 determines, based on the read/write temperature, that a memory corresponding to the data is the first PCM 1 or the main memory 2, and stores the data in the corresponding memory. For all stored data, the controller 3 determines, each time periodicity duration elapses, that a read/write temperature of the data is hot, warm, or cold based on the read/write frequency of the data within the current periodicity duration, and then re-determines a memory of the data based on the read/write temperature of the data. If the newly determined memory is different from a memory in which the data is currently located, the data is migrated to the newly determined memory.

### Method 3

When receiving to-be-stored data sent by a CPU 4, the controller 3 temporarily does not determine a read/write temperature of the data, and stores the data in a pre-specified memory (where the first PCM 1 or the main memory 2 may be specified). For all stored data, the controller 3 determines, each time periodicity duration elapses, that a read/write temperature of the data is hot, warm, or cold based on the read/write frequency of the data within the current periodicity duration, and then re-determines a memory of the data based on the read/write temperature of the data. If the newly determined memory is different from a memory in which the data is currently located, the data is migrated to the newly determined memory. In this way, after one piece of periodicity duration, a read/write temperature of the newly stored data may be determined, and then the newly stored data may continue to be stored in the first PCM 1 or may be migrated to the main memory 2.

In addition, for some consumer-level application scenarios (in which the device is sometimes disabled for long time), some data protection mechanisms in a normal power-off case may be set in the controller 3. The controller 3 is configured to: when receiving a device to-be-disabled instruction, migrate data in the first PCM 1 to the main memory 2, and feed back a completion notification after the migration is completed; and after the device is enabled, migrate the data that is migrated to the main memory 2 back to the first PCM 1.

In addition, a corresponding wear leveling algorithm may further be set in control logic of the controller 3. In other words, when an address is allocated to data to be stored in the first PCM 1 or the main memory 2, address allocation is performed according to a wear leveling principle, to be specific, a memory cell with a minimum quantity of writing times is selected, and an address of the memory cell is allocated to the to-be-stored data.

In an actual application, the controller 3 may support various bus communication standards, and perform communication based on a corresponding bus communication standard such as a parallel bus communication standard, a serial bus communication standard, or a customized bus communication standard.

In an actual application, various communication protocols may be used between the controller 3 and the main memory 2, for example, an open not and flash interface (open NAND flash interface, ONFI) protocol, a toggle (a communication standard name) protocol, or a proprietary protocol.

In the foregoing control logic of the controller 3, the controller 3 stores the data with a higher read/write temperature in the first PCM 1, and stores the data with a lower read/write temperature in the main memory 2. In this way, because a CPU frequently reads and writes data that is the data with a higher read/write temperature and seldom performs a read/write operation on the data with a lower read/write temperature, a latency indicated by the storage device to the outside is mainly the latency of the first PCM 1, and the latency of the main memory 2 is basically not perceived by the outside of the storage device. In addition, provided that it is ensured to some extent that the ratio of a total capacity of the first PCM 1 to a total capacity of the main memory 2 is matched with the ratio of the hot data, the warm data, and the cold data of the computer device, storage space of the first PCM 1 and the main memory 2 can be fully used. In this way, an advantage of high storage density and a large capacity of the main memory 2 can be well utilized, and it can be ensured that a problem of a high latency of the main memory 2 does not cause an excessively large impact on the latency indicated by the entire storage device to the outside, that is, an advantage of a low latency of the first PCM 1 can be fully utilized.

Based on the foregoing descriptions of the parts of the storage device and the functions of the parts, a person skilled in the art may set, based on an actual application scenario and a cost requirement, the latency of the first PCM 1, the latency of the main memory 2, the storage capacity of the first PCM 1, the storage capacity of the main memory 2, the read/write temperature corresponding to the first PCM 1, and the read/write temperature corresponding to the main memory 2. There are many possible corresponding application scenarios. For example, the storage device is used as a memory in a server of an application, or the storage device is used as a memory in a user terminal.

For example, the storage device is used as the memory in the server of the application. In a running process of the server of the application, data amounts and a ratio of hot data, warm data, and cold data in the memory are generally stable. A skilled person may determine, based on historical statistics, the data amounts and the ratio of the hot data, the warm data, and the cold data in the memory in a general state. In addition, whether the warm data is stored in the first PCM 1 or the main memory 2 is determined based on cost and service requirements, and it is assumed that storing of the warm data in the first PCM 1 is determined, to be specific, it is set that the hot data and the warm data are stored in the first PCM 1 and the cold data is stored in the main memory 2. Further, the storage capacity of the first PCM 1 may be determined based on the foregoing collected data amounts of the hot data and the warm data of the application, and the storage capacity of the main memory 2 may be determined based on the foregoing collected data amount of the cold data of the application. If the application does not have a very high requirement on a memory latency, a material with a latency of about 20 ns may be used to produce the first PCM 1. The main memory 2 stores the cold data. Therefore, the latency of the main memory 2 has no impact on the latency of the entire storage device, and a material with a latency of 300 ns to 500 ns may be used to produce the main memory 2.

In embodiments of this application, a PCM with a lower latency is used as a cache. The PCM medium with the low latency can still have high storage density while the latency is as low as 20 ns, and can reach a GB-level large storage capacity. In addition, data can be retained for a few days after a power failure, and a power failure protection mechanism does not need to be set, thereby reducing costs. The controller stores the data with a higher read/write temperature in the PCM, and stores the data with a lower read/write temperature in the main memory. In this way, an advantage of high storage density and a large capacity of the main memory can be well utilized, and it can be ensured that a problem of a high latency of the main memory does not cause an excessively large impact on the latency indicated by the entire storage device to the outside. In a 3D packaging manner, the PCM and the controller are located in different dies, so that the PCM and the controller do not repeatedly occupy an area, and an occupied area can be reduced. In addition, the PCM and the controller are connected through a line in a vertical direction, and the line in the vertical direction does not occupy an area, thereby further reducing the occupied area. In addition, in the 3D packaging manner, the PCM and the controller may be connected to a large quantity of lines. In this way, a conventional operation circuit does not need to be disposed inside the PCM. Correspondingly, the controller may directly perform a read/write operation on data in the PCM, and is not limited by a conventional protocol between the controller and the operation circuit, so that data read/write is more flexible and efficient.

An embodiment of this application provides a storage device. Refer to FIG. 2. A structure of the storage device may be as follows.

The storage device includes a first PCM 1, a main memory 2, a controller 3, and a PCB 5. The main memory 2 is a second PCM (where the second PCM has high storage density, and may be referred to as a high-density PCM). The first PCM 1 and the controller 3 are packaged in a CPU 4 in a 3D packaging manner, and the first PCM 1 and the controller 3 are in different dies of the CPU 4. The PCB 5 has a DDR interface 51. The main memory 2 is disposed on the PCB 5. A latency of the first PCM 1 is less than that of the second PCM, and storage density of the second PCM is greater than that of the first PCM 1.

In the foregoing structure, the storage device is divided into two independent parts. The first part includes the second PCM and the PCB 5. The second part includes the first PCM 1 and the controller 2 that are packaged in the CPU 4 in a 3D packaging manner.

### First part

The second PCM is disposed on the PCB 5, the PCB 5 has the DDR interface 51, and the second PCM is connected to the DDR interface 51 through a line on the PCB 5. The second PCM and the controller 3 may be compatible with the DDR JEDEC standard. In this way, the second PCM and the PCB 5 form a standard memory module of a DDR interface. Different from a conventional memory module that is of a DDR interface and that uses a DRAM chip, the memory module in this embodiment of this application uses a PCM chip. The memory module may be inserted into a DIMM slot of a mainboard of a computer device. In this way, the second PCM may communicate with the controller 2 in the CPU 4 through a parallel bus.

The second PCM may include a storage medium and an operation circuit. The operation circuit may directly read or write data in the storage medium. The controller 3 communicates with the operation circuit based on a corresponding protocol. The operation circuit performs a corresponding read/write operation based on an indication of the controller 3, and feeds back a result to the controller 3.

It should be noted that, when the second PCM is compatible with the DDR JEDEC standard, the PCM memory module does not necessarily need to be used together with the second part, that is, does not necessarily need to be used together with the CPU 4 packaged with the first PCM 1 and the controller 2, and may also be used with an ordinary CPU. When the PCM memory module is used together with the ordinary CPU, the PCM memory module is equivalent to an ordinary memory module, and an only difference lies in that a PCM chip is used as a memory chip.

### Second part

An entirety including the first PCM 1 and the controller 2 may be a physically relatively independent unit in the CPU 4. In this case, it may be considered that the first PCM 1, the second PCM, and the controller 3 jointly form a memory. The controller 2 may work based on an indication of a memory control unit of the CPU 4, and manage the first PCM 1 and the second PCM. The second PCM is a main memory in the memory and exists in a form of a memory module. The first PCM 1 is a cache in the memory and is embedded in the CPU 4. There is an on-chip connection line between the memory control unit of the CPU 4 and the controller 2, and the memory control unit of the CPU 4 and the controller 2 may communicate with each other through the on-chip connection line. The memory control unit may send to-be-stored data, a data read address, or the like to the controller 2 inside the CPU 4, and the controller 2 sends read data, a response message, or the like to the memory control unit inside the CPU 4. In this way, a latency of communication between the memory control unit and the controller 2 can be greatly reduced, and transmission efficiency can be improved.

Alternatively, the first PCM 1 may be used as a cache of the CPU 4, for example, a level 4 (L4) cache, and the controller 2 may be a storage control unit of the CPU 4. There are a plurality of specific implementations. For example, each level of cache has an independent cache control unit. In addition, there is a memory control unit in the CPU 4. A combination of the memory control unit and a cache control unit corresponding to the first PCM 1 may be referred to as the controller 2, and the memory control unit and the cache control unit corresponding to the first PCM 1 are respectively responsible for controlling the first PCM 1 and the second PCM.

For a function of the controller 3, refer to the foregoing content in embodiments of this application.

In embodiments of this application, the storage device may completely replace a standard DRAM memory module. Compared with a common DRAM memory module, the storage device has a low-latency cache, where the cache has a large storage capacity, and the entire storage device uses non-volatile memories, and has a good anti-power-off capability. The controller stores data with a higher read/write temperature in a low-latency PCM, and stores data with a lower read/write temperature in a high-density PCM. In this way, an advantage of high storage density and a large capacity of the main memory can be well utilized, and it can be ensured that a problem of a high latency of the main memory does not cause an excessively large impact on a latency indicated by the entire storage device to the outside. The latency indicated by the storage device to the outside mainly depends on a latency of the low-latency PCM. In addition, the controller communicates with another unit in the CPU through on-chip communication, and the low-latency PCM also communicates with the controller through on-chip communication. This can effectively reduce a latency of data read/write on the low-latency PCM, in other words, can effectively reduce a latency of data read/write on the entire storage device. In a 3D packaging manner, the PCM and the controller are located in different dies, so that the PCM and the controller do not repeatedly occupy an area, and an occupied area can be reduced. In addition, the PCM and the controller are connected through a line in a vertical direction, and the line in the vertical direction does not occupy a chip area, thereby further reducing the occupied area. In addition, in the 3D packaging manner, the PCM and the controller are connected at a chip level, and may be connected to a large quantity of lines. Therefore, the controller may directly perform a read/write operation on data in the PCM. In this way, a conventional operation circuit does not need to be disposed inside the PCM. Correspondingly, data read/write on the PCM is not limited by a conventional protocol between the controller and the operation circuit, so that data read/write is more flexible and efficient.

In content of the foregoing embodiment, the high-density PCM is used as the main memory. Certainly, a NAND memory may also be used as the main memory. A feature of the NAND memory is close to a feature of the high-density PCM. Details are not described in this embodiment of this application. In addition, based on the foregoing various structures, a communication protocol between the controller 3 and the CPU 4 may be a general protocol or a proprietary protocol.

An embodiment of this application provides a storage device. A structure of the storage device may be as follows.

The storage device includes a first PCM 1, a main memory 2, a controller 3, and a PCB 6. The main memory 2 is a second PCM. The first PCM 1 and the controller 3 are packaged in a same chip in a 3D packaging manner, and the first PCM 1 and the controller 3 are in different dies of the chip. Both the 3D packaging chip and the second PCM are disposed on the PCB 6. The PCB 6 has a serial bus interface or a customized bus interface. A latency of the first PCM 1 is less than that of the second PCM, and storage density of the second PCM is greater than that of the first PCM 1.

For a function of the controller 3, refer to the foregoing content in embodiments of this application.

In this structure, the storage device is a complete integrated hardware module, and the chip in which the first PCM 1 and the controller 3 are packaged and the second PCM are connected to a same PCB. The controller 3 is connected to the second PCM through a line on the PCB to perform communication, and the controller 3 is connected to the first PCM 1 through a line in a vertical direction in the chip to perform communication. The second PCM may include a storage medium and an operation circuit. The operation circuit may directly read or write data in the storage medium. The controller 3 communicates with the operation circuit based on a corresponding protocol. The operation circuit performs a corresponding read/write operation based on an indication of the controller 3, and feeds back a result to the controller 3.

The structure has many possible module forms. The following provides several possible module forms.

### Module form 1: DIMM module as shown in FIG. 3

A DDR interface 61 is disposed on the PCB 6. The controller 3 supports a serial bus communication standard or a customized bus communication standard, and the storage device may communicate with the CPU 4 based on the serial bus communication standard or the customized bus communication standard. A hardware module of the entire storage device is a DIMM module. Different from a common DIMM module that uses a DRAM chip and a parallel bus communication standard, the storage device uses a high-density PCM chip and the serial bus communication standard or the customized bus communication standard. In this solution, a customized design may be performed on the CPU 4, so that the CPU 4 communicates with the DIMM module based on the serial bus communication standard or the customized bus communication standard, and the CPU 4 supports accessing the DIMM module based on memory semantics or customized semantics on a serial bus or a customized bus.

The storage device in the module form can use a DIMM slot that is on a standard mainboard and that is well compatible with the existing mainboard. The storage device may be used as a memory or a supplementary memory of a DRAM memory.

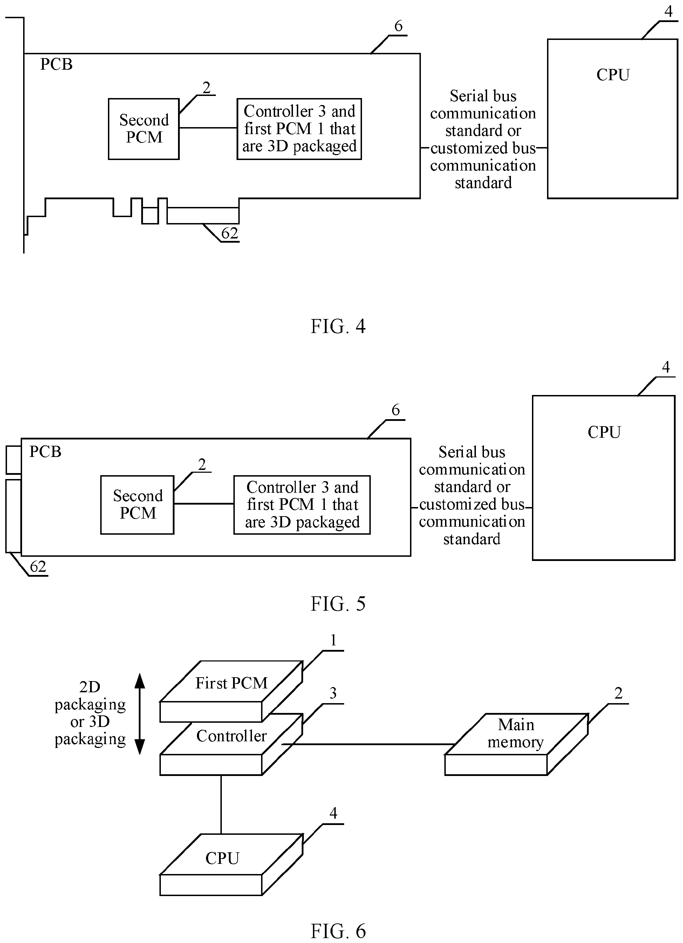

### Module form 2: PCIe drive as shown in FIG. 4 or FIG. 5

A PCIe interface 62 is disposed on the PCB 6. The controller 3 supports a serial bus communication standard or a customized bus communication standard, and the storage device communicates with the CPU 4 based on the serial bus communication standard or the customized bus communication standard. A hardware module of the entire storage device is a PCIe drive, and the PCIe drive has many different forms. FIG. 4 and FIG. 5 show two specific forms. Different from a common PCIe drive that uses a DRAM to store an address mapping table and that uses a NAND chip, the storage device may use a low-latency PCM to store an address mapping table and use a high-density PCM chip as the main memory.

In the module form, the storage device and the CPU 4 may communicate with each other based on a PCIe protocol, and the storage device supports input/output (input/output, I/O) semantic access, in other words, supports block addressing. In this way, the storage device may be used as a solid-state drive.

In the module form, the storage device and the CPU 4 may also communicate with each other based on the compute express link (compute express link, CXL) protocol. The storage device supports both memory semantic access and I/O semantic access, in other words, supports both byte addressing and block addressing. In this way, the storage device may be used as a solid-state drive, or may be used as a supplementary memory.

As the solid-state drive, the storage device can reflect a low latency to the outside by using the low-latency PCM and a mechanism that the controller 3 performs storage scheduling on data based on a read/write temperature. If the storage device is used as the solid-state drive, an average access latency can be reduced to 1 microsecond (*µs*). As the supplementary memory, the storage device has high storage density, and can reach a TB-level storage capacity. In addition, corresponding control logic may be set in a system program or an application, and storage scheduling is performed between the DRAM memory and the storage device based on a read/write temperature of data (where the storage scheduling may be considered as level-1 scheduling, and storage scheduling performed by the controller 3 inside the storage device may be considered as level-2 scheduling), so that the DRAM memory stores data with a higher read/write temperature, and the storage device stores data with a lower read/write temperature. In this way, although an inherent latency of the PCIe interface is high, the foregoing solution can ensure that a latency indicated by an entire memory including the memory and the supplementary memory to the outside is not affected by the inherent latency of the PCIe interface.

In content of the foregoing embodiment, the high-density PCM is used as the main memory. Certainly, a NAND memory may also be used as the main memory. A feature of the NAND memory is close to a feature of the high-density PCM. Details are not described in this embodiment of this application. In addition, based on the foregoing various structures, a communication protocol between the controller 3 and the CPU 4 may be a general protocol or a proprietary protocol.

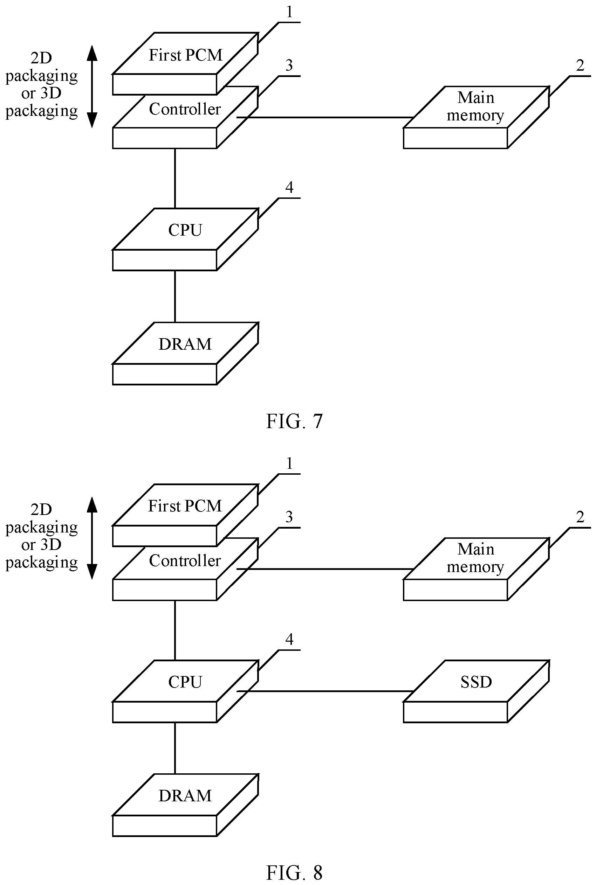

An embodiment of this application further provides a computer device. The computer device includes the storage device in the foregoing embodiments. After the computer device is equipped with the storage device, the computer device may be equipped with a DRAM or may not be equipped with the DRAM. FIG. 6 shows a case in which a computer device is not equipped with a DRAM, where the storage device may be used as a memory. FIG. 7 shows a case in which a computer device is equipped with a DRAM, where the DRAM is used as a memory, and the storage device may be used as a supplementary memory, or may be used as an SSD. FIG. 8 shows a case in which a computer device is equipped with a DRAM, an SSD, and the foregoing storage device. The DRAM is used as a memory, and the storage device may be used as a supplementary memory, or may be used as an SSD used together with an original SSD, or may be used as a high-speed cache disk of the original SSD.

A person of ordinary skill in the art may understand that all or some of the steps of embodiments may be implemented by hardware or a program instructing related hardware. The program may be stored in a computer-readable storage medium. The storage medium may be a read-only memory, a magnetic disk, an optical disc, or the like.

The foregoing descriptions are merely embodiments of this application, but are not intended to limit this application. Any modification, equivalent replacement, or improvement made without departing from the spirit and principle of this application should fall within the protection scope of this application.

## Claims

1. A storage device, wherein the storage device comprises a first phase change memory PCM (1), a main memory (2), and a controller (3), wherein
the first PCM (1) and the controller (3) are packaged in a same chip;
a latency of the first PCM (1) is less than that of the main memory (2), and storage density of the main memory (2) is greater than that of the first PCM (1); and
the controller (3) is configured to store data in the first PCM (1) and the main memory (2) based on a read/write temperature of the data, wherein the first PCM (1) is a cache of the main memory (2).

2. The storage device according to claim 1, wherein the packaging is three-dimensional 3D packaging, and the first PCM (1) and the controller (3) are in different dies of the chip.

3. The storage device according to claim 1, wherein the controller (3) is configured to perform a read/write operation on the first PCM (1).

4. The storage device according to claim 1, wherein the main memory (2) is a second PCM or a not and NAND memory.

5. The storage device according to claim 1, wherein the first PCM (1) is a gigabyte GB-level memory, and the main memory (2) is a terabyte TB-level memory; or
the first PCM (1) is a megabyte MB-level memory, and the main memory (2) is a GB-level memory.

6. The storage device according to any one of claims 1 to 5, wherein the first PCM (1) and the controller (3) are packaged in a central processing unit CPU (4).

7. The storage device according to claim 6, wherein the storage device further comprises a printed circuit board PCB (5) having a double data rate DDR interface (51), and the main memory (2) is disposed on the PCB (5).

8. The storage device according to any one of claims 1 to 5, wherein the storage device further comprises a PCB (6), and the chip and the main memory (2) are disposed on the PCB (6).

9. The storage device according to claim 8, wherein the PCB (6) has a DDR interface (61).

10. The storage device according to claim 8, wherein the PCB (6) has a high-speed serial computer expansion bus standard PCIe interface (62).

11. The storage device according to claim 10, wherein a communication protocol between the controller (3) and a CPU (4) is a PCIe protocol or a compute express link CXL protocol.

12. The storage device according to any one of claims 1 to 10, wherein a communication protocol between the controller (3) and a CPU (4) is a proprietary protocol.

13. The storage device according to any one of claims 1 to 10, wherein the controller (3) supports a parallel bus communication standard, a serial bus communication standard, or a customized bus communication standard.

14. The storage device according to any one of claims 1 to 13, wherein a communication protocol between the controller (3) and the main memory (2) is an open not and flash interface ONFI protocol, a toggle protocol, or a proprietary protocol.

15. A computer device, wherein the computer device comprises the storage device according to claims 1 to 14.
